# EUROPEAN PATENT APPLICATION

(11) **EP 4 840 612 A1**
(43) Date of publication of application: **18.11.2026**
(21) Application number: 26177953.2
(22) Date of filing: 11.05.2026
(51) Int. Cl.: B29C 45/37, B29C 45/26, B60R 16/023, H01R 9/24, H01R 13/46, H01R 43/20, H05K 3/00, H05K 7/02, B29L 31/34, B29L 31/36, H01H 85/20

(54) **POLYMERIC OR COMPOSITE MASKS FOR PRINTED CIRCUIT BOARDS WITH RECONFIGURABLE CAVITY ARRANGEMENTS**

(30) Priority: 12.05.2025 IT 202500010584
(71) Applicant: MTA S.p.A., 26845 Codogno (Lodi) (IT)
(72) Inventor: Rossi, Marco, 26814 Livraga (LO) (IT); Cinquetti, Giancarlo, 26823 Castiglione d'Adda (LO) (IT); Cipolla, Alessandro, 26010 Montodine (CR) (IT)
(74) Representative: Perani & Partners S.p.A.

(57) **Abstract**

A kit (100) for injection moulding of masks (5) of polymeric or composite material, for printed circuit boards (3) for electrical power boxes (1), comprises a mould housing (110) into which polymeric or composite material is to be injected, with a support matrix (114) which has support areas (115) arranged in a matrix. Mould modules (120) are configured to mould respective areas of the mask (5) with respective module arrangements (55) of connection through-cavities (53) for electrical and/or electronic components (6). The mould modules (120) are fixed in the support areas (115), with positions interchangeable between the support areas (115), to obtain different overall arrangements (54) of cavities (53) of the mask (5). The mask (5) is used in an electrical power box (1) between a printed circuit board (3) and electrical and/or electronic components (6). The kit (100) allows for making different masks (5), and for updating existing ones, by replacing individual modules (120), instead of the entire mould.

## Description

### Technical field

The present invention relates to the technical field of electrical power boxes for automotive applications, in particular power boxes with fuses, relays or other plug-in components.

### Background art

The electrical power boxes of vehicles usually comprise a frame with connectors for external wiring connections, a printed circuit board connected to the connectors and a series of electrical and/or electronic components connected to the printed circuit board, such as fuses, relays or other plug-in components. However, frameless power boxes are also known. It is also known to position a perforated polymeric or composite mask between the printed circuit board and the electrical and/or electronic components. The connection between them is thus made through the cavities of the mask, while the mask performs functions of protection and insulation of the printed circuit board and support for the electrical and/or electronic components.

### Problem of the prior art

The masks are injection moulded in suitable moulds. Since the power boxes are mass-produced, the same mould is used to produce a long series of masks. The mould, however, cannot be reused for masks of different power boxes, due to the arrangement of cavities to be obtained, which is generally different from one power box to another and designed to optimise in each case the connections of the electrical and/or electronic components to the printed circuit board.

Therefore, a power box manufacturer must bear the cost of a new mould for each new power box model to be produced. This is particularly disadvantageous when the purchaser of the power boxes decides to make minor changes to the design of a power box already in production, for example, moving, replacing or adding a component, with the need to move one or more cavities of the mask. In fact, in this case, however small the modification, it is still necessary to make a new mould, while the mould for the previous model becomes unusable. Thus, even this small modification entails a significant cost.

### Summary of the invention

The object of the present invention is to solve the drawbacks discussed with reference to the prior art, and in particular to reduce the costs of starting the moulding of new versions of a polymeric or composite mask for printed circuit boards.

This and other objects are achieved by a kit and a method for injection moulding masks of polymeric or composite material, a mask, and an electrical power box according to any one of the appended claims.

The invention provides for the use of an injection mould with mould modules suitable for being arranged in a matrix in the mould with interchangeable positions. The mould modules are suitable for moulding respective portions of the mask with respective module arrangements of connection cavities. The matrix union of the different module arrangements thus forms the overall arrangement of connection cavities in the mask.

The Applicant has in fact observed that most power box designs include similar electrical and/or electronic components, which require, at least locally, similar cavity arrangements, although the overall arrangement is different.

The Applicant has thus conceived a collection of mould modules to obtain locally the most requested cavity arrangements, or in any case a sufficient variety of possible local cavity arrangements to meet the needs of the different designs, once the modules are placed side-by-side in a matrix in the most suitable way for the design of interest.

Advantageously, when the production of one mask must be interrupted and the production of a different mask must be started, it is not necessary to replace the entire mould, but it is sufficient to reposition and/or replace some of its mould modules. This is particularly advantageous when only small modifications are made to the design. Even when starting the production of completely different masks 5, there is the advantage of being able to continue using at least the mould housing, and perhaps some modules, already in use previously, for their entire useful life, without having to discard these components prematurely just because their mask is no longer required.

In some embodiments, the invention is also suitable for moulding masks of different sizes with the same mould, by adapting the mould modules, creating a mould with dimensions suitable for the largest mask and reducing the number of rows and/or columns of modules used in the matrix arrangement, for moulding the smaller mask.

Further features and advantages of the invention will be recognisable to a person skilled in the art from the following detailed description of exemplary embodiments of the invention.

### Brief description of the figures

For a better understanding of the following detailed description, some embodiments of the invention are illustrated in the accompanying drawings, in which:
- figure 1 shows a perspective view of an electrical power box for automotive applications, with a mask according to an embodiment of the invention,
- figure 2 shows an exploded view of the power box of figure 1,
- figure 3 shows a plan view of the mask of the power box of figure 1,
- figures 4 and 5 show plan views of masks with reduced dimensions according to other embodiments of the invention,
- figure 6 shows a perspective view of a detail of the mask of figure 5, mounted on a printed circuit board,
- figures 7a-7c show perspective views of a kit for injection moulding of polymeric or composite masks, according to an embodiment of the invention, used for moulding masks with different formats, and
- figure 8 shows a perspective view of the action of two mould modules of the kit of figure 7 in moulding an area of a mask.

### DETAILED DESCRIPTION

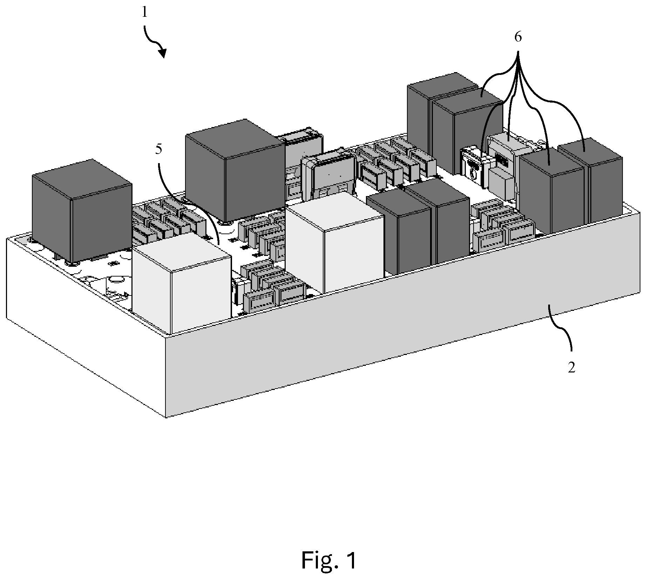

First, with particular reference to figures 1-2, some known features of an electrical power box 1 for automotive applications, also applicable to a power box 1 according to an embodiment of the invention, are described.

In the illustrated embodiments, the power box 1 comprises a frame 2, usually polymeric, with a compartment 21 for a printed circuit board. The frame 2 can be made in a single piece or in several pieces assembled together, for example a frame base 23 and a frame cover 24 which enclose the compartment 21 between them. The compartment 21 can therefore be a substantially closed compartment, for example for sealed waterproof applications, but it can also be an open compartment 21, when no cover is present but the compartment 21 is delimited only at the bottom and sides.

It is however possible to make the power box 1 without a frame 2, limiting it to the other elements described below.

The power box 1 comprises a printed circuit board 3, disposed in the frame 2, if present, in particular in the compartment 21. In a known manner, the printed circuit board 3 comprises a board 31 of insulating material, a plurality of electrical contact elements 32, on one or both faces of the board 31, and a plurality of conductors (not shown) which electrically connect distinct contact elements 32 to each other. The printed circuit board 3 can also comprise basic circuit elements, such as resistors, diodes and capacitors, connected between distinct contact elements 32.

Connectors 4 for external wiring connections are connected to the printed circuit board 3. The connectors 4 thus allow the electrical connection of the power box 1, and in particular of the printed circuit board 3, to other electrical devices of the vehicle.

The frame 2, if present, has a plurality of connection openings 22, in which the connectors 4 are mounted. The connectors 4 can be arranged on any side of the frame 2, for example on a lower side, directly facing the printed circuit board 3, or on an upper side, with the mask 5, described below, disposed between the connectors 4 and the printed circuit board 3.

The power box 1 in fact comprises a mask 5, disposed on the printed circuit board 3. Thus, where the frame 2 is present, the mask 5 is located in the compartment 21. The mask 5 comprises a panel-like substrate 51, of polymeric or composite material, which can be fixed to the frame 2, with or without contact with the printed circuit board 3, or can be supported directly by the printed circuit board 3. In the preferred embodiment, the mask 5 comprises a plurality of feet 52 that protrude from the substrate 51 towards the printed circuit board 3, to rest on the printed circuit board 3, in particular on the board 31.

It should be noted, however, that the feet 52 are preferably formed in one piece with the substrate 51, in the same injection moulding operation, but they could also not be formed in one piece with the substrate 51, and be assembled to it at a later time. Therefore, where the injection moulding of the mask 5 will be described below, reference will be primarily intended to the substrate 51 of the mask 5 and not necessarily also to the feet 52.

The substrate 51 has a plurality of connection through-cavities 53 for electrical and/or electronic components. These connection cavities 53 are aligned with the contact elements 32 of the printed circuit board 3, to allow connection to the contact elements 32 from the opposite side of the substrate 51. The connection cavities 53 of the substrate 51 together define an overall cavity arrangement 54, more details of which will be given below.

The power box 1 finally comprises a plurality of electrical and/or electronic components 6, disposed in the compartment 21 on the mask 5. Thus the mask 5 is interposed between the electrical and/or electronic components 6 and the printed circuit board 3.

Preferred examples of electrical and/or electronic components 6 are plug-in components such as various models of fuses and relays, but other plug-in components such as diodes, shunts and direct electrical connections can also be contemplated. More generally, the electrical and/or electronic components 6 have electrical terminals, which are aligned with the cavities 53 of the mask 5, and are connected to the contact elements 32 of the printed circuit board 3 through the through-cavities 53 of the mask 5.

Preferred examples of contact elements 32 that simplify this connection are contact elements 32 that protrude from the printed circuit board 3 towards the mask 5.

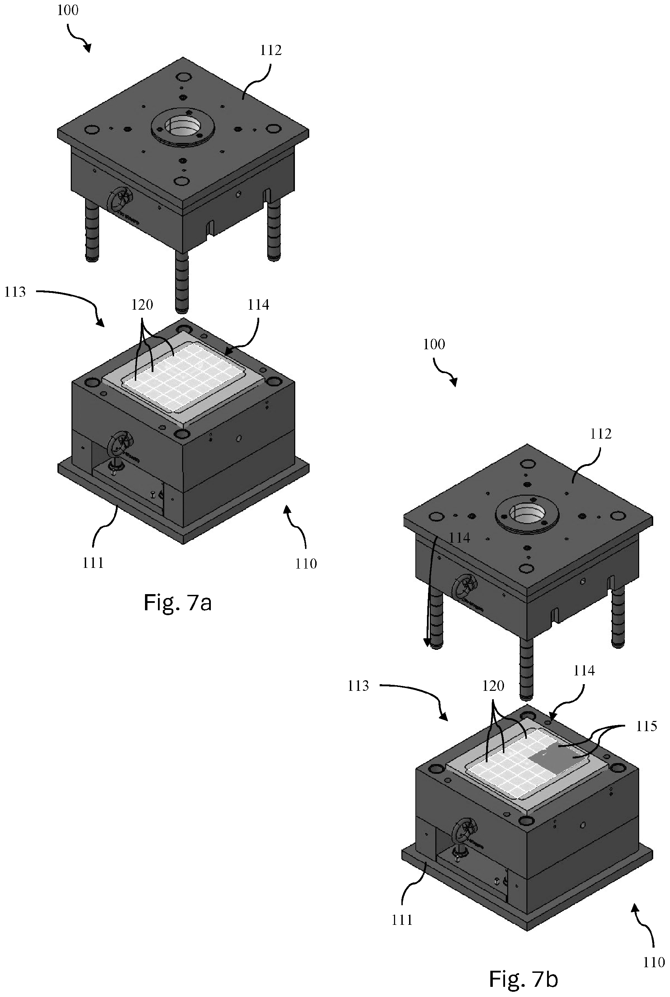

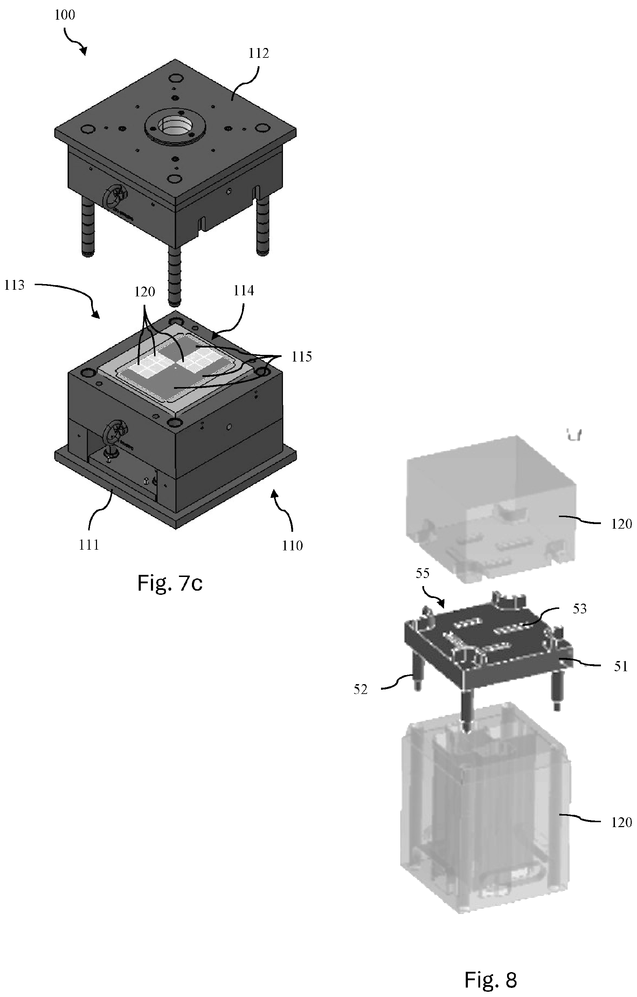

In order to mould the masks 5, the invention provides a kit 100, shown in figures 7a-7c, which comprises a mould housing 110 and a plurality of mould modules 120, two of which are shown in figure 8. When assembled, the housing 110 and the modules 120 form two half-moulds for injection moulding, into which molten polymeric or composite material (compound, usually filled polymer) is injected between the two half-moulds.

In more detail, the housing 110 comprises a mould base 111 and a mould cover 112, which are configured to be fixed together, enclosing therebetween an internal mould volume 113. The mould modules 120 are positioned in the internal volume 120 and contribute to defining the shape of the mask 5 to be moulded. In fact, even after the insertion of the modules 120, part of the internal volume 113 remains free for the injection of the polymeric or composite material and the moulding of the mask 5.

The modules 120 of the kit 100 are usually more numerous than those necessary for the moulding of a single mask 5, in order to allow the production of several different masks 5.

The mould housing 110 has a support matrix 114 in the internal volume 113, for mounting the modules 120. The support matrix 114 comprises a plurality of support areas 115 arranged in a matrix, each configured for the removable fixing of a mould module 120. In particular, the support matrix 114 has an overall number of rows and an overall number of columns of support areas 115.

The support areas 115 have in plan view shapes and dimensions corresponding to the shapes and dimensions in plan view of the mould modules 120. Preferably, the kit 100 includes fixing means for fixing the respective modules 120 to the support areas 115. The fixing can occur for example by means of screws, or by snap-fitting. The modules 120 can also include fixing means for fixing them to each other, for example by interlocking.

Thus, the mould modules 120 are configured to be arranged in a matrix in the internal volume 113, on the support matrix 114.

The support matrix 114 can be formed in the base 111 only, in the cover 112 only, or in both. In fact, the modules 120 can be fixed partly to the base 111 and partly to the cover 112, or in other embodiments they can be fixed to only one of them. Thus, one of the half-moulds can be defined by the base 111 and some modules 120, while the other half-mould can be defined by the cover 112 and some modules 120, but in some cases there can be a half-mould defined by the base 111 only or by the cover 112 only.

Each mould module 120 is configured to mould an area of the mask 5. If the modules 120 are provided in both the base 111 and the cover 112, each area of the mask 5 is generally moulded on two faces by distinct modules 120, facing each other and fixed one to the base 111 and the other to the cover 112. These modules 120 operating on opposite faces of the same area of the mask 5 are shown in figure 8.

Some mould modules 120 are configured, individually, to form, in the moulding of the mask 5, connection through-cavities 53 arranged according to a respective module arrangement 55. The connection cavities 53 are obtained generally by means of reliefs on the module 120, which prevent the molten polymeric or composite material from occupying the volume dedicated to the cavity 53 in the mould. Therefore, the arrangement of the reliefs on the module 120 also corresponds to the module arrangement 55 of the connection cavities 53 that the module 120 will form in the mask 5.

The cavities 53 of each module arrangement 55 are arranged in such a way as to allow the connection to the printed circuit board 3 of at least one electrical and/or electronic component 6, optionally plural electrical and/or electronic components 6, but in any case in a limited number, for example up to 3 or 4 electrical and/or electronic components 6.

Since the modules 120 are arranged in a matrix, and each moulds a portion of the mask 5, the cavities 53 of each module arrangement 55 are a subset of the cavities 53 of the overall arrangement 54, and thus the overall arrangement 54 is defined by the matrix union of the module arrangements 55.

It is not excluded that some "blank" modules 120 may also be provided, configured to mould the respective areas of the mask 5 without connection cavities 53.

Among all the modules 120 of the kit 100, some identical modules 120 and some different modules 120 are usually provided. Identical modules 120 are in fact useful when a certain number of identical electrical and/or electronic components 6 must be connected to the printed circuit board 3. Different modules 120 are instead useful to allow connecting a variety of electrical and/or electronic components 6 to the printed circuit board 3 according to a variety of positions.

Thus, the mould modules 120 are subdivided into a plurality of types. All the mould modules 120 of the same type are identical to each other, that is, they are identical in terms of perimeter shape in plan view, dimensions in plan view, and module arrangement 55 of cavities 53. In contrast, when comparing modules 120 of different types, these are different at least in their respective module arrangements 55 that they mould, but they can be identical in terms of perimeter shape in plan view and dimensions in plan view.

The invention in fact provides that mould modules 120 of different types, thus mould modules 120 that produce different module arrangements 55, can be fixed to the support matrix 114 in interchangeable support areas 115. This allows obtaining, with the same modules 120, different overall arrangements 54 of connection cavities 53 of the mask 5.

In fact, to obtain a new overall arrangement 54 for an updated mask 5, starting from a starting overall arrangement 54 of a preceding mask 5, one can for example exchange the position of several modules 120 between different support areas 115, and/or replace one or more modules 120 in use with modules 120 of the kit 100 of different types, which were not used for the preceding mask 5, or were used only in different support areas 115.

In the preferred embodiment, to obtain the possibility of positioning the modules 120 in interchangeable support areas 115, all the modules 120 have, in plan view, the same perimeter shape and dimensions.

A suitable perimeter shape for the purpose of matrix arrangement with interchangeability for the modules 120, and thus for the support areas 115, is a rectangular shape. The preferred shape is a square shape (which is intended as a particular case of a rectangular shape). In fact, the square shape allows not only the matrix positioning of the modules 120 in interchangeable areas 115, but also allows the fixing of each module 120 in the same support area 115 according to several orientations rotated with respect to each other by a predetermined angle, in particular 90°. The possible use of other polygonal or circular shapes is not intended to be excluded.

In the preferred embodiment, as illustrated in the figures, all the types of modules 120 have in plan view the same perimeter shape and the same dimensions. This therefore also applies to the support areas 115.

However, embodiments are not excluded in which the interchangeability of positions is partially limited, by providing that, although some different types of modules 120 have in common the perimeter shape in plan view and the dimensions in plan view, one or more types of modules 120 may be different from the others in the perimeter shape in plan view and/or in the dimensions in plan view.

In this case, there may be first support areas 115 suitable for the connection of a first group of types of modules 120, and second support areas 115, different from the first support areas 115 and suitable for the connection of a second group of types of modules.

Alternatively, all the support areas 115 could be identical to each other, but a first group of types of modules 120 could be provided, with perimeter shapes in plan view and dimensions in plan view individually corresponding to those of the support areas 115, and a second group of types of modules 120, with perimeter shapes in plan view and dimensions in plan view corresponding to multiples and/or fractions of the support areas 115. For example, there could be modules 120 that each occupy two support areas 115, and/or modules 120 that each occupy half a support area 115.

In the preferred embodiment, the kit 100 allows moulding not only masks 5 with different overall arrangements 54 of cavities 53, but also masks 5 of different dimensions.

In fact, as already mentioned, the support matrix 114 has an overall number of rows and an overall number of columns of support areas 115. However, not all of these are necessarily used in the moulding of a mask. In particular, the overall arrangement of cavities 54 of the mask 5 can be composed of the matrix union of module arrangements 55 according to a reduced number of rows only, or a reduced number of columns only, or a reduced number of rows and columns, with respect to the overall numbers of rows and columns.

For this purpose, the overall numbers of rows and columns of the support matrix 114 can be chosen in accordance with the dimensions of the largest masks 5 that are expected to be moulded. In an exemplary embodiment, the perimeter shapes and dimensions of the modules 120 and of the support areas 115 are selected such that the masks 5 with standard dimensions correspond to a 6*3 matrix, but in order to be able to mould larger masks 5 if necessary, a mould with a 7*5 support matrix 114 can be made.

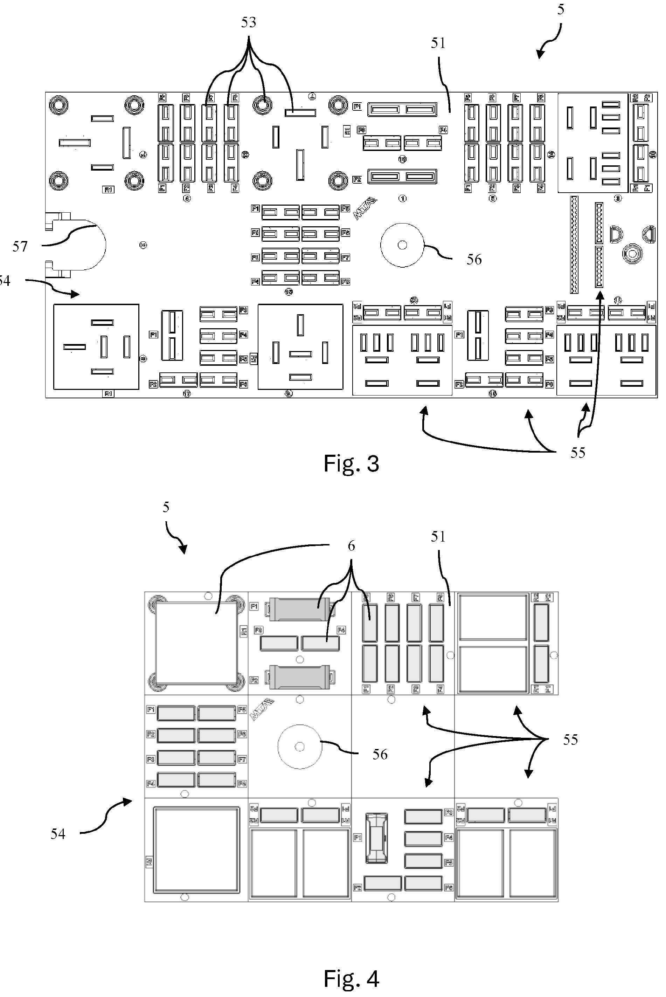

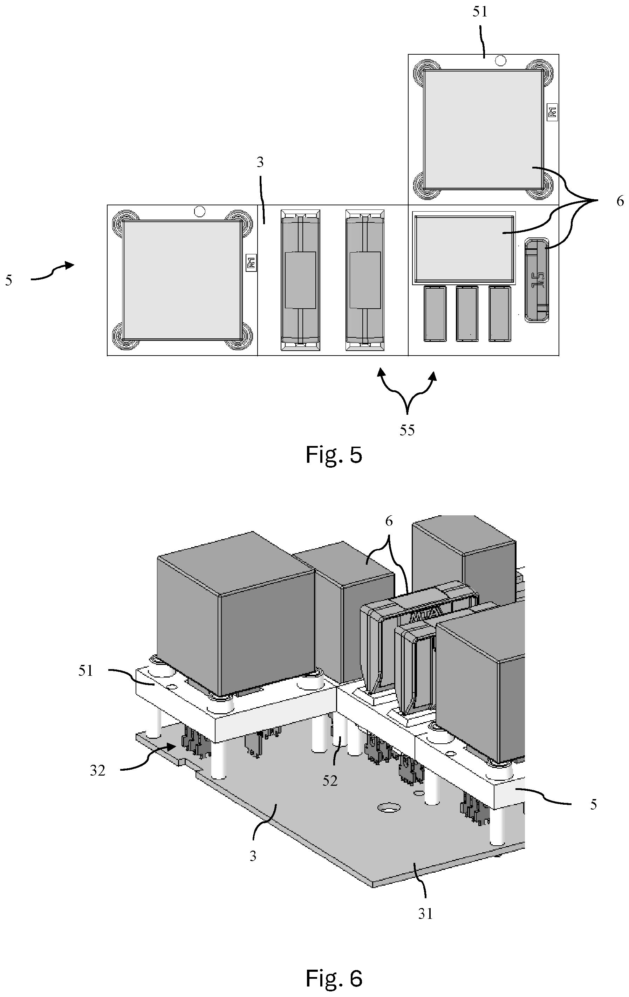

To mould instead masks 5 of reduced dimensions with respect to the maximum possible, the support matrix 114 is usable in a reduced manner, by fixing to it mould modules 120 arranged according to reduced numbers of rows and/or columns, smaller than the corresponding overall numbers. Figures 3-5 show masks 5 composed of matrices with different numbers of rows and columns, and figures 7a-7c show processes for moulding masks with different numbers of rows and columns.

In reduced moulding, some support areas 115 are therefore not occupied by modules 120. These areas 115 can for example be left free, and in this case they are filled with polymeric or composite material which will be separated from the obtained mask 5. Alternatively, the areas 115 without modules 120 can be occupied by barriers suitable for preventing the access of molten polymeric or composite material into the respective area 115 without modules 120.

In some embodiments, as in figure 7c, the support matrix 114 can also be divided into several sub-matrices to mould a plurality of masks 5, identical or different from each other, in a single moulding operation.

In still other examples, as in figures 4-5 and 7b, one or more rows or columns can be incomplete, leaving space for example for the connection of one or more electrical and/or electronic components 6 directly to the printed circuit board 3, without the interposition of the mask 5.

Having described the moulding kit 100 and its operating modes so far, a moulding method according to the invention can provide the steps of:
- receiving a design of a mask 5 for printed circuit boards 3,
- organising the mould modules 120 in the mould housing 110 according to a matrix arrangement, in conformity with the design, and
- using the mould housing 110 with the mould modules 120 to injection mould the mask 5, by introducing molten polymeric or composite material into the mould housing 110.

In particular, the design reports the desired overall arrangement 54 of cavities 53. Thus, in organising the modules 120 in a matrix, the matrix arrangement is chosen in such a way that the matrix union of the module arrangements 55 corresponds to the overall arrangement 54.

In a particular case, the method starts from an existing mask 5 design (previous design), moulded with a kit 100 according to the invention with a certain starting matrix arrangement of modules 120 (previous matrix). It is therefore desired to mould a new mask 5 design (updated design), where at least one mould module 120 is distinct from the previous mask 5 design. The other mould modules 120 are instead in common between the previous design and the updated design, that is, they are modules 120 that produce the same module arrangements 55 and are disposed in the same positions in the two designs.

In this case, organising the modules 120 in the housing 110 comprises replacing, in the matrix arrangement of the previous design, each mould module 120 that distinguishes the two designs, while maintaining the common mould modules 120 in their original positions.

A mask 5 that is obtained with the method or the kit 100 of the invention can be recognised in that its overall arrangement 54 of cavities 53 is the matrix union of multiple module arrangements 55 of cavities 53. It will therefore be possible in the overall arrangement 54 to identify division lines in rows and columns, which do not intersect the cavities 53, and which subdivide the matrix 5 into areas with identical perimeter shapes and dimensions, as they correspond to distinct modules 120. These lines are shown in figures 4-5, and are recognisable, although not represented, in figure 3. Among them will be found areas with different module arrangements 55 of the cavities 53. These are, however, preferably, theoretical lines, which do not correspond to traces present on the surface of the substrate 51.

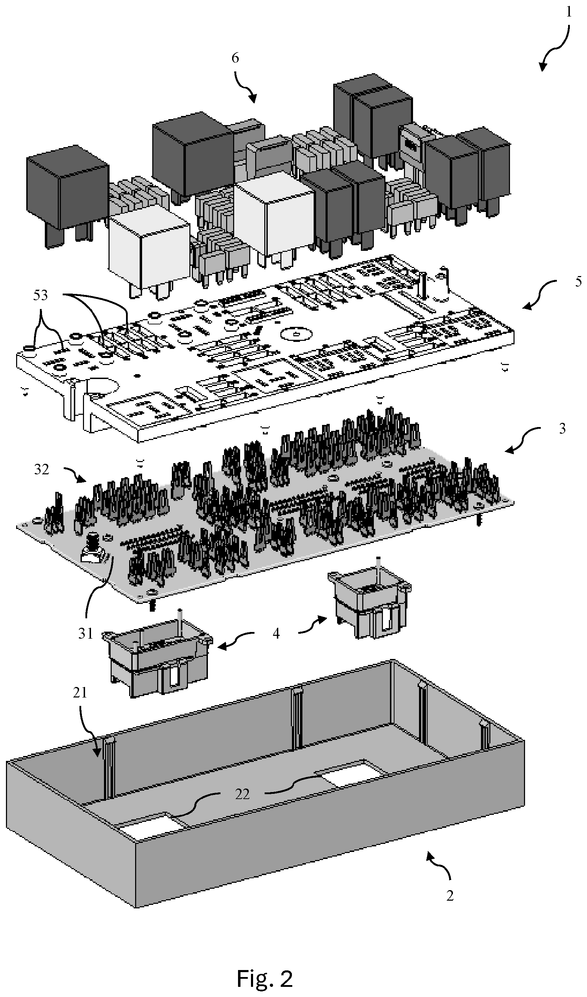

It should be noted that some of the areas of the matrix could then be moulded with standard shapes, without the aid of modules 120. Examples of these areas are visible in figures 2-4, and in particular an area in which an impression of an injection nozzle 56 for the polymeric or composite material is recognised, and an area in which an anti-rotation recess 57 for additional components such as terminals is shown.

Obviously, a person skilled in the art may make numerous equivalent modifications to the variants described above, without thereby departing from the scope of protection defined by the appended claims.

## Claims

1. Kit (100) for injection moulding of masks (5) made of polymeric or composite material for printed circuit boards (3) for electrical power boxes (1) for automotive applications, comprising:
- a mould housing (110) comprising a mould base (111) and a mould cover (112), the base and the cover (111, 112) being configured to be fixed together, enclosing therebetween an internal mould volume (113) for injecting therein polymeric or composite material to obtain a mask (5),
wherein the mould housing (110) has a support matrix (114) in the internal volume (113), the support matrix (114) having a plurality of support areas (115) arranged in a matrix,
- a plurality of mould modules (120), configured to mould respective areas of the mask (5) with respective module arrangements (55) of connection through-cavities (53) for electrical and/or electronic components (6),
wherein the mould modules (120) are configured to be fixed in a removable manner in the support areas (115), with positions of distinct mould modules (120) interchangeable between distinct support areas (115), to obtain different overall arrangements (54) of connection cavities (53) of the mask (5).

2. Kit (100) according to claim 1, wherein the support areas (115) and the mould modules (120) have a rectangular or square perimeter shape in plan view, preferably square.

3. Kit (100) according to claim 1 or 2, wherein the mould modules (120) are subdivided into a plurality of types, the mould modules (120) of at least some distinct types being configured to mould distinct module arrangements (55) of cavities (53), and having equal perimeter shapes in plan view and dimensions in plan view.

4. Kit (100) according to any one of claims 1 to 3, wherein the module arrangements (55) of cavities are individually arrangements with cavities (53) suitable for the connection of terminals of one or more plug-in components, such as fuses and/or relays, to a printed circuit board (3).

5. Kit (100) according to any one of claims 1 to 4, wherein the support matrix (114) has overall numbers of rows and columns of support areas (115), and is suitable for being used for a reduced moulding, in which mould modules (120) are fixed to it arranged according to reduced numbers of rows and/or columns, smaller than the corresponding overall numbers.

6. Method for moulding masks (5) of polymeric or composite material for printed circuit boards (3) for electrical power boxes (1) for automotive applications, comprising:
- receiving a design of a mask for printed circuit boards (3), with a predetermined overall arrangement (54) of connection cavities (53) for electrical and/or electronic components (6),
- organising a plurality of mould modules (120) in a mould housing (110) according to a matrix arrangement,
wherein the mould modules (120) are configured to mould respective areas of the mask (5) with respective module arrangements (55) of connection cavities (53),
wherein the matrix arrangement is selected such that the matrix union of the module arrangements (55) corresponds to the overall arrangement (54) of connection cavities (53), and
- using the mould housing (110) with the plurality of mould modules (120) to injection mould the mask (5).

7. Method according to claim 6, wherein:
- the mask design is an updated mask design, with a plurality of mould modules (120) in common with a preceding mask design and at least one mould module (120) distinct from the preceding mask design, and
- organising the plurality of mould modules (120) in the housing (110) comprises replacing, in the matrix arrangement of the preceding design, the at least one distinct mould module (120).
